# EUROPÄISCHE PATENTSCHRIFT

(11) **EP 0 934 794 B1**
(45) Veröffentlichungstag und Bekanntmachung des Hinweises auf die Patenterteilung: **07.05.2003**
(21) Anmeldenummer: 99102217.9
(22) Anmeldetag: 22.01.1999
(51) Int. Cl.: B23K 20/00, B23K 20/10, G10K 11/00, B06B 3/00

(54) **Ultraschallgeber mit einem Flansch zur Befestigung an einem Ultraschallschweissgerät, insbesondere an einem Wire-Bonder**
Ultrasonic generator having a support flange for mounting the generator onto an ultrasonic welding machine, in particular a wire bonder
Générateur d'ultrasons ayant une flasque pour la fixation sur une machine de soudage par ultrasons, en particulier pour le microcablage

(30) Priorität: 26.01.1998 EP 98810063
(43) Veröffentlichungstag der Anmeldung: 11.08.1999
(73) Patentinhaber: ESEC Trading SA, 6330 Cham (CH)
(72) Erfinder: Parrini, Lorenzo, Dr. sc. nat., 8003 Zürich (CH)
(74) Vertreter: Falk, Urs, Dr.

(56) Entgegenhaltungen:
- US-A- 2 891 179
- US-A- 5 364 005
- US-A- 5 368 216
- US-A- 5 595 328
- US-A- 5 603 445

## Beschreibung

Die Erfindung betrifft einen Ultraschallgeber mit einem Flansch der im Oberbegriff des Anspruchs 1 genannten Art.

Solche Ultraschallgeber werden bei Ultraschallschweissgeräten aller Art, beispielsweise bei Wire-Bondern verwendet. Ultraschallgeber der im Oberbegriff des Anspruchs 1 genannten Art sind aus den Patentschriften US 5 603 445, US 5 595 328 und US 5 364 005 bekannt, wobei US 5 595 328 den nächslügenden Stand der Technik darstellt. Zur Befestigung des Ultraschallgebers am Ultraschallschweissgerät ist ein Flansch vorhanden, der in einem sogenannten longitudinalen Knoten der im Horn des Ultraschallgebers angeregten, longitudinalen stehenden Ultraschallwellen angebracht ist Da in einem Knoten der longitudinalen Ultraschallwellen aber Schwingungsbäuche von radialen Schwingungen auftreten, ist der Flansch nur über Stege mit dem Horn verbunden, um die Übertragung von Ultraschallenergie vom Horn auf den Flansch und weiter auf das Ultraschallschweissgerät möglichst zu unterbinden. Die Übertragung von Ultraschallenergie könnte aus energetischer Sicht durchaus hingenommen werden. Weitaus gravierendere Nachteile sind jedoch darin zu sehen, dass die elektrische Impedanz des Ultraschallgebers nicht reproduzierbar und nicht konstant ist und dass die Art und Weise, wie die Spitze des Horns schwingt, selbst bei energetisch unbedeutender Übertragung von Ultraschallenergie vom Horn auf das Schweissgerät noch immer von diversen Umständen abhängt, z.B. davon, wie stark die Schrauben angezogen sind, mit denen der Flansch am Schweissgerät befestigt ist. Die Schwingungen der Spitze des Horns hängen auch davon ab, wie die Kapillare am Horn befestigt ist, wie z.B. den Patentschriften US 5 180 093 und US 5 368 216 zu entnehmen ist.

Der Erfindung liegt die Aufgabe zugrunde, einen Ultraschallgeber mit einem Flansch zur Befestigung an einem Ultraschallschweissgerät vorzuschlagen, bei dem die oben genannten Nachteile behoben sind. Eine weitere Aufgabe besteht darin, das Horn des Ultraschallgebers so auszubilden, dass seine Spitze auch bei Beaufschlagung mit Ultraschallwellen hoher Frequenz kontrollierbare Schwingungen vollzieht.

Die genannten Aufgaben werden erfindungsgemäss gelöst durch die Merkmale des Anspruchs 1.

Gemäss der Erfindung wird die Aufgabe dadurch gelöst, dass die linearen Abmessungen des Flansches derart gross bemessen sind, dass sich im Flansch stehende, radiale Ultraschallwellen ausbilden, die mindestens einen Knoten aufweisen. Ein solcher Knoten wird im folgenden als radialer Knoten bezeichnet. Die Bohrungen zur Befestigung des Flansches am Ultraschallschweissgerät mittels Schrauben, z.B. an einem Wire-Bonder, sind in diesen Knoten angeordnet. Die die Bohrungen unmittelbar umgebende Fläche, die in direktem Kontakt mit dem Ultraschallschweissgerät ist, schwingt daher praktisch nicht mit und es erfolgt keine oder nur eine sehr geringe Übertragung von Ultraschallenergie vom Horn auf das Ultraschallschweissgerät über den Flansch. Der Ultraschallgeber und das Ultraschallschweissgerät sind somit mechanisch vollständig entkoppelt. Die Restmenge an Ultraschallenergie, die vom Horn auf das Ultraschallschweissgerät übertragen wird, ist vernachlässigbar klein.

Nachfolgend wird ein Ausführungsbeispiel der Erfindung anhand der Zeichnung näher erläutert.

Es zeigen:
- Fig. 1a: einen Ultraschallgeber mit einem Flansch in der Draufsicht,
- Fig. 1b, c: die Amplitude der sich im Horn des Ultraschallgebers bzw. im Flansch ausbildenden, stehenden Ultraschallwellen bei Erregung mit einer vorbestimmten Resonanzfrequenz,
- Fig. 2a-c, 3a, b, 4a, b, 5a, b,: Resultate mathematischer Berechnungen,
- Fig. 6: die Spitze des Horns des Ultraschallgebers,
- Fig. 7: ein Befestigungsmittel,
- Fig. 8: ein Frequenzspektrum, und
- Fig. 9: eine Befestigungsart für den Flansch an einem Ultraschallschweissgerät.

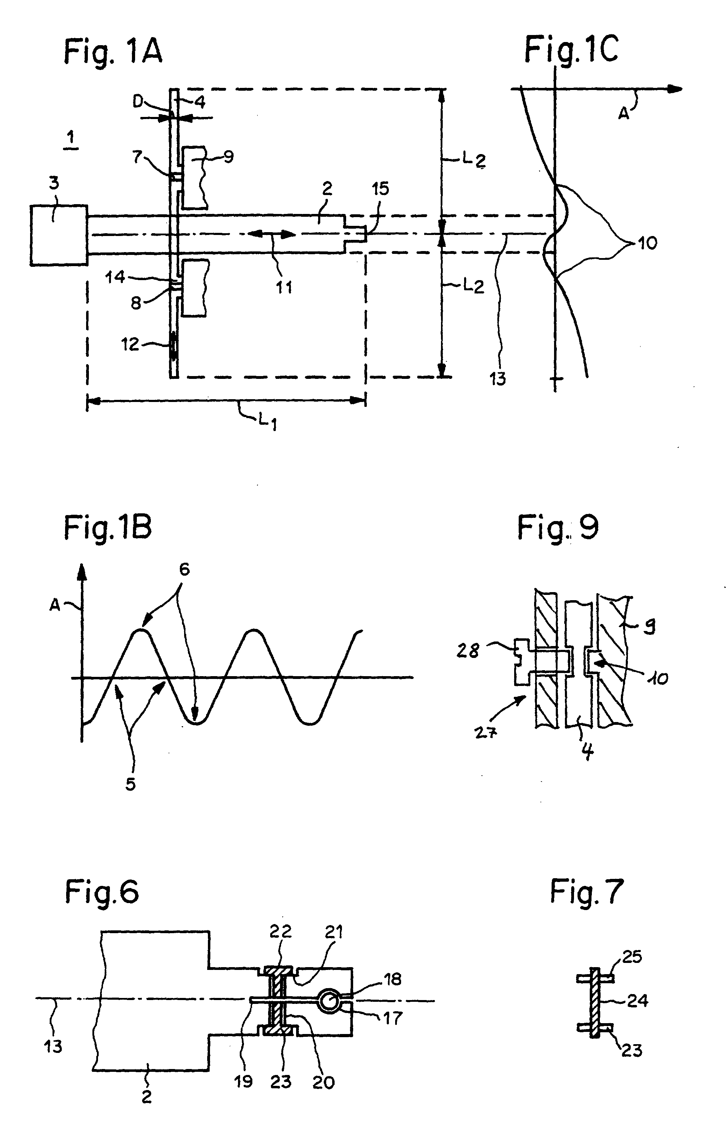

Die Fig. 1a zeigt in der Draufsicht einen Ultraschallgeber 1 mit einem länglichen Horn 2 und mit einem Ultraschallwandler 3, der das Horn 2 mit Ultraschallwellen beaufschlagt. In Längsrichtung des Horns 2 bilden sich bei Erregung des Horns 2 durch den Ultraschallwandler 3 mit einer Resonanzfrequenz stehende Ultraschallwellen aus: Die Ultraschallwellen weisen sogenannte longitudinale Knoten 5 (Fig. 1b) sowie Schwingungsbäuche 6 auf, deren Lage und Anzahl von der Länge L₁ des Horns 2, von der Schallgeschwindigkeit der Ultraschallwellen im Material des Horns 2 und von der Frequenz der vom Ultraschallwandler 3 erzeugten Ultraschallwellen abhängt.

Die Fig. 1b zeigt die Amplitude A der Ultraschallwellen entlang des Horns 2 bei Erregung des Horns 2 durch den Ultraschallwandler 3 mit einer vorbestimmten Resonanzfrequenz f_{R}. Die Resonanzfrequenz f_{R} ist z.B. mit etwa 124 kHz so hoch gewählt, dass sich entlang des Horns 2 fünf longitudinale Knoten 5 ausbilden. Am Ort des zweiten Knotens 5 der Ultraschallwellen ist der Flansch 4 (Fig. 1a) am Horn 2 angeordnet. Der Flansch 4 und das Horn 2 sind als ein Teil hergestellt Der Flansch 4 ist symmetrisch bezüglich der Längsachse des Horns 2 ausgebildet und weist beidseitig des Horns 2 je eine Bohrung 7 bzw. 8 auf, damit der Ultraschallgeber 1 mittels Schrauben an einem Ultraschallschweissgerät 9, z.B. an einem Wire-Bonder, befestigt werden kann. Im Flansch 4 breiten sich radial gerichtete Ultraschallwellen aus. Die Länge L₂ des Flansches 4 ist nun erfindungsgemäss derart bemessen, dass sich bei Beaufschlagung des Horns 2 mit der Resonanzfrequenz f_{R} im Flansch 4 ebenfalls stehende Ultraschallwellen ausbilden, die mindestens einen Knoten 10 (Fig. 1c) aufweisen. Diese Knoten 10 heissen radiale Knoten. Die Bohrungen 7 und 8 sind in diesen Knoten 10 angeordnet. Die Schwingungsrichtung der Ultraschallwellen im Horn 2 und im Flansch 4 ist mit Pfeilen 11 bzw. 12 dargestellt. Unter longitudinaler Schwingung ist eine sich in Längsrichtung des Horns 2 ausbreitende Schwingung zu verstehen, unter radialer Schwingung ist eine sich quer zur Längsachse des Horns 2 ausbreitende Schwingung zu verstehen. Die Länge L₂ wird gemessen von der Symmetrieachse 13 des Horns 2 bis zur Spitze des Flansches 4.

Mit Vorteil ist, wie in der Fig. 1a dargestellt ist, der Flansch 4 im Bereich der Bohrungen 7, 8 etwas dicker ausgebildet. Somit sind nur Flächen 14 des Flansches 4, die die Bohrungen 7, 8 unmittelbar umgeben, mit dem Ultraschallschweissgerät 9 in Kontakt. Der Ultraschallgeber 1 ist ultraschallmässig vollständig vom Ultraschallschweissgerät 9 entkoppelt und kann deshalb praktisch ohne Reibung am Ultraschallschweissgerät 9 frei schwingen. Möglich ist auch eine Lösung, bei der der Flansch 4 mit konstanter Dicke D ausgeführt ist. In diesem Fall ist die den Flansch 4 berührende Kontaktfläche des Ultraschallschweissgerätes 9 entsprechend klein auszubilden.

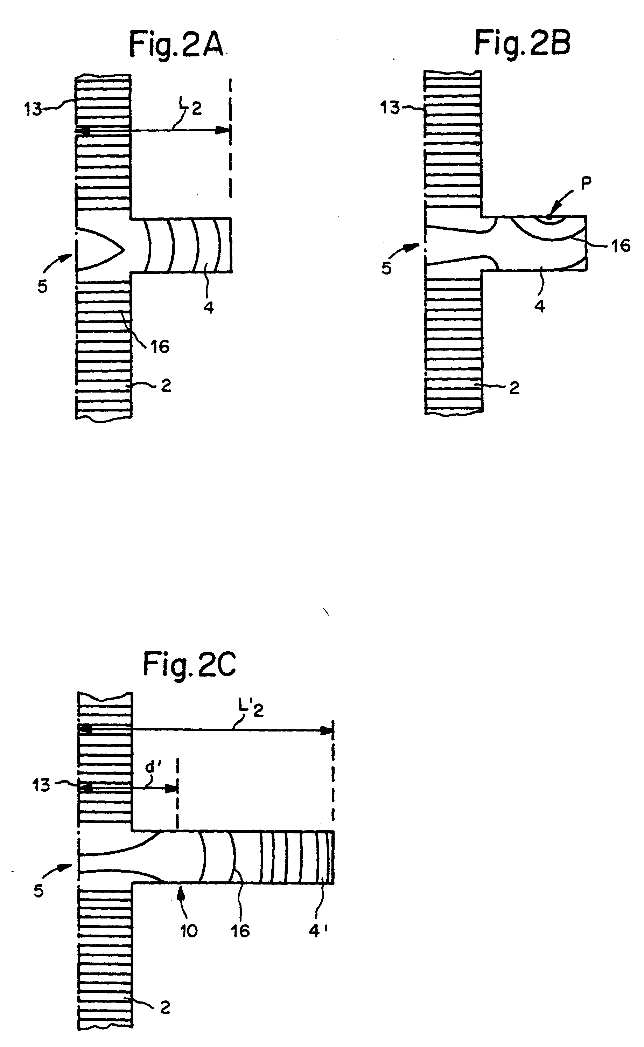

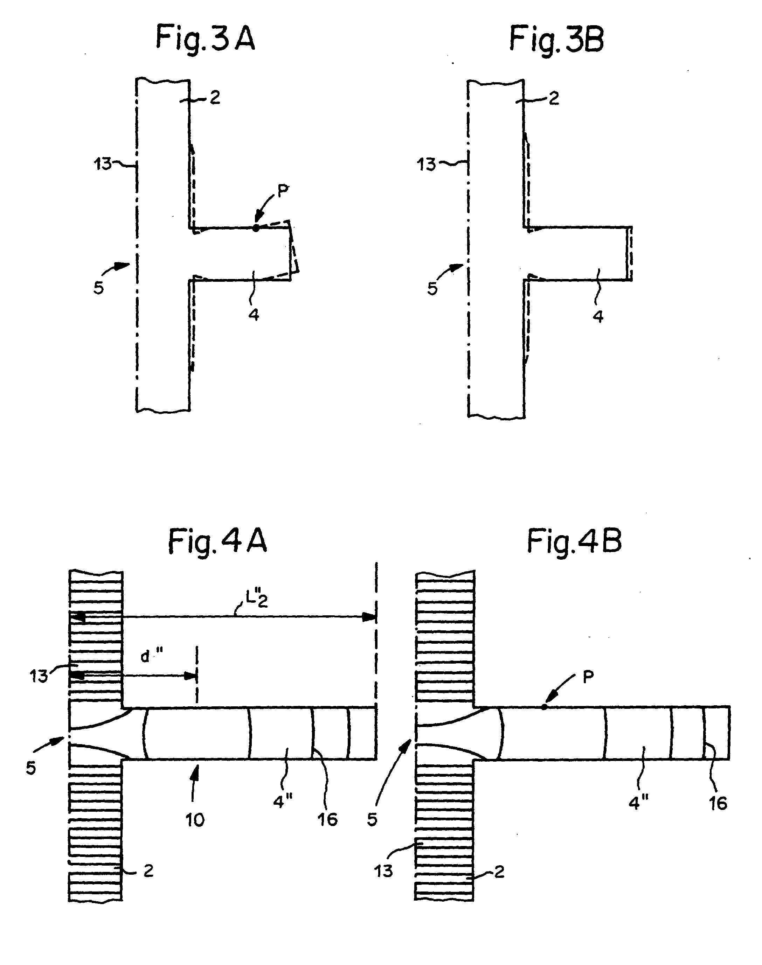

Die Fig. 2a-c und später die Fig. 4a und b zeigen Resultate mathematischer Berechnungen, wobei Linien 16 gezeichnet sind, deren Abstand proportional zur lokalen Schwingungsamplitude der Ultraschallwellen ist. Ein kleiner Abstand bedeutet, dass das entsprechende Gebiet vergleichsweise stark schwingt, während ein grosser Abstand bedeutet, dass das entsprechende Gebiet vergleichsweise wenig schwingt oder sogar vollständig in Ruhe ist.

Die Fig. 2a zeigt einen in einem der longitudinalen Knoten 5 des Horns 2 angebrachten Flansch 4 herkömmlicher Art, d.h. einen Flansch mit relativ kurzer Länge L₂, der frei schwingen kann, wobei das Horn 2 als Horn für einen Wire-Bonder vorgesehen ist. Der herkömmliche Flansch 4 weist eine Länge L₂ = 9 mm auf. Aus Symmetriegründen ist nur die bezüglich der Symmetrieachse 13 des Horns 2 rechts gelegene Seite des Flansches 4 gezeichnet, die die Bohrung 8 enthält. Das Horn 2 wird vom Ultraschallwandler 3 (Fig. 1a) mit der vorbestimmten Resonanzfrequenz f_{R} erregt, so dass sich in Längsrichtung stehende, longitudinale Ultraschallwellen ausbilden. Im Flansch 4 kann sich aufgrund seiner zu kurzen Länge L₂ bei der Frequenz f_{R} kein radialer Knoten ausbilden. Die Fig. 2b zeigt denselben Flansch 4, bei dem im Zentrum der Bohrung 7 (Fig. 1a) ein mathematischer Punkt P fixiert ist. Aus den Fig. 2a und b ist ersichtlich, dass das Schwingungsverhalten des herkömmlichen Flansches 4 stark davon abhängig ist, ob der Flansch 4 frei schwingen kann oder ob er am Punkt P fixiert ist. In der Praxis variiert die Lage des Punktes P infolge unvermeidlicher Toleranzen, was zur Folge hat, dass der aktuelle Ort, an dem die Schrauben den Flansch 4 gegen das Ultraschallschweissgerät 9 pressen und die aktuelle Kraft, die sie dabei lokal auf den Flansch 4 ausüben, die Schwingungen der Spitze 15 des Horns 2 in unerwünschtem Ausmass beeinflussen. Die Schwingungen der Spitze 15 des Horns 2 sind somit nicht reproduzierbar. Da im Punkt P Kräfte auftreten, geht zudem ein Teil der Ultraschallenergie durch Reibung am Befestigungspunkt P verloren.

Die Fig. 2c zeigt einen erfindungsgemässen Flansch 4', d.h. einen Flansch mit relativ grosser Länge L₂', der frei schwingen kann. Im Rechenbeispiel ergab sich als optimale Länge L₂' = 16 mm. Wenn das Horn 2 mit der ausgewählten Resonanzfrequenz f_{R} angeregt wird, bilden sich im Flansch 4' radiale Ultraschallwellen aus, die ebenfalls einen Knoten 10 aufweisen. Der Knoten 10 befindet sich in einem Abstand d' = 5 mm von der Symmetrieachse 13 des Horns 2. Wenn die Bohrungen 7, 8 zur Befestigung des Ultraschallgebers 1 in diesen Knoten 10 angebracht sind, ändert sich das Schwingungsverhalten des Horns 2 nicht, wenn der Ultraschallgeber 1 am Ultraschallschweissgerät 9 befestigt wird. Das Horn 2 und das Ultraschallschweissgerät 9 können somit mechanisch vollständig entkoppelt werden, so dass die Schwingungen der Spitze 15 des Horns 2 nicht mehr davon abhängen, ob und mit welcher Kraft der Flansch 4' am Ultraschallschweissgerät 9 befestigt ist.

Die Fig. 3a zeigt einen weiteren Nachteil des herkömmlichen Flansches 4. Wenn der Flansch 4 am Punkt P fixiert ist, verbiegt er sich bei Beaufschlagung des Horns 2 mit Ultraschallwellen. Im Vergleich dazu stellt die Fig. 3b den frei schwingenden, herkömmlichen Flansch 4 dar, der sich nicht verbiegt. Die ausgezogene Randlinie zeigt den Ruhezustand des Horns 2 bzw. Flansches 4. Die gestrichelte Randlinie zeigt das Horn 2 bzw. den Flansch 4 im Zustand mit maximaler Schwingungsamplitude. Die Auslenkung der Spitze des Flansches 4 ist in Phase mit der Auslenkung des Horns 2 beim Knoten 5 in radialer Richtung. Diese Verbiegungsschwingungen führen dazu, dass einerseits der Flansch 4 am Ultraschallschweissgerät 9 rüttelt und dass andererseits wegen der Rückwirkung auch unerwünschte Biegeschwingungen im Horn 2 auftreten können. Die Schwingungen der Spitze 15 des Horns 2 sind nicht reproduzierbar, weil die Stärke der Biegeschwingungen des Horns 2 von der Kraft abhängen kann, mit der die Schrauben den Flansch 4 gegen das Ultraschallschweissgerät 9 pressen. Beim erfindungsgemässen Flansch 4' tritt am Punkt P keine Verbiegung auf.

Die Simulationen zeigen, dass die Resonanzfrequenz f_{R} und damit die Lage der longitudinalen Knoten 5 (Fig. 1b) leicht variieren in Funktion der Länge L₂' des erfindungsgemässen Flansches 4'. Es ist daher angezeigt, die Lage des Flansches 4' der Verschiebung der Lage der Knoten 5 nachzuführen und so Lage und Länge L₂' iterativ zu optimieren.

Um bestehende Wire-Bonder mit einem Ultraschallgeber 1 mit einem solchen Flansch nachrüsten zu können, ohne mechanische Änderungen am Wire-Bonder vornehmen zu müssen, darf die Lage der Bohrungen 7, 8 nicht verändert werden, d.h. deren Abstand d" von der Symmetrieachse 13 des Horns 2 ist fest vorgegeben. Die Länge L₂" des Flansches ist daher gemäss der Erfindung derart zu bemessen, dass sich der Knoten 10 unter der Voraussetzung, dass der Flansch frei schwingen kann, möglichst am Ort der Bohrung 7 bzw. 8 ausbildet. Die Fig. 4a zeigt einen weiteren frei schwingenden Flansch 4", bei dem sich ein radialer Knoten 10 in unmittelbarer Nähe der Bohrung 7 ausbildet. Im Rechenbeispiel ergab sich für den Abstand d" = 7 mm der Bohrungen 7, 8 von der Symmetrieachse 13 des Horns 2 eine optimale Länge L₂" = 18 mm. Die Fig. 4b zeigt den weiteren Flansch 4', bei dem nun am vorgegebenen Ort der Bohrung 7 ein mathematischer Punkt P fixiert ist. Aus den Fig. 4a und 4b ist ersichtlich, dass die Lösung mit der Länge L₂" = 18 mm eine praktikable Lösung ist, bei der das Schwingungsverhalten des Flansches 4" auch kaum davon abhängig ist, ob der Flansch 4" frei schwingen kann oder ob er am Punkt P fixiert ist.

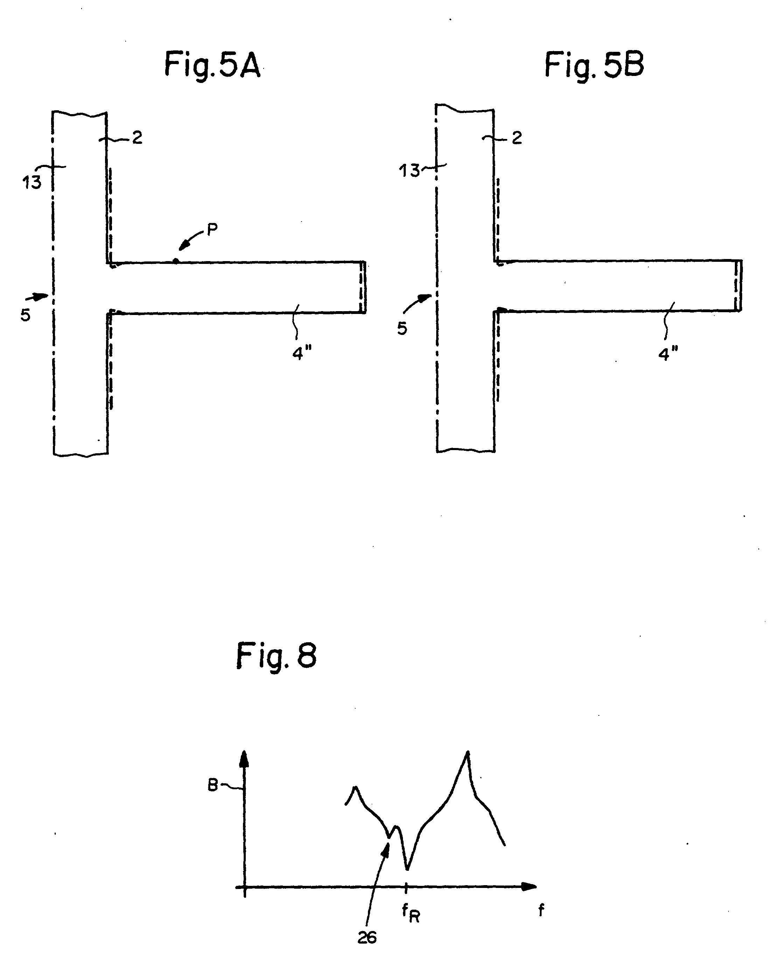

Die Fig. 5a und 5b zeigen, dass sich der am Punkt P fixierte, erfindungsgemäss befestigte weitere Flansch 4" (Fig. 5a) bei Beaufschlagung des Horns 2 mit Ultraschallwellen nicht verbiegt und sehr ähnlich schwingt wie der frei schwingende Flansch 4" (Fig. 5b). Die Auslenkung der Spitze des Flansches 4 ist hier gegenphasig zur Auslenkung des Horns 2 beim Knoten 5 in radialer Richtung.

Die Erfindung lässt sich auch bei anderen Horntypen anwenden, z.B. bei einem bezüglich seiner Längsachse symmetrisch ausgebildeten Horn wie es beispielsweise die Patentschrift US 5 469 011 offenbart. Der erfindungsgemässe Flansch 4' kann auch statt am Horn 2 am Ultraschallwandler 3 angeordnet sein. Dabei ist zu bemerken, dass unter dem Begriff Horn im weitesten Sinn auch eine Halterung für die den Ultraschall erzeugenden Elemente (aus z.B. piezoelektrischen oder magnetostrictiven Werkstoffen) zu verstehen ist, d.h. in diesem Fall bilden Ultraschallwandler 3 und Horn 2 (Fig. 1a) ein einziges Teil.

Beim bisherigen Ausführungsbeispiel wird der Flansch 4 mittels Schrauben am Ultraschallschweissgerät 9 befestigt, wozu der Flansch 4 in den Knoten 10 angeordnete Bohrungen 7 und 8 aufweist. Grundsätzlich sind auch andere Befestigungsarten möglich, bei denen der Flansch 4 keine Bohrungen aufweist, sondern beispielsweise mit an den Knoten 10 angreifenden Klemmmitteln am Ultraschallschweissgerät 9 befestigt ist. Bei einer solchen Lösung weist der Flansch 4 am Ort des Knotens 10 vorzugsweise noch eine Nut auf, in die das Befestigungsmittel und/oder das Gegenstück am Ultraschallschweissgerät 9 eingreift. Die Fig. 9 zeigt ein solches Beispiel. Als Klemmmittel dient hier eine in die Nut 27 eingreifende Schraube 28, die im Knoten 10 auf den Flansch 4 drückt.

Die Fig. 6 zeigt im Detail die Spitze des Horns 2. Das Horn 2 ist bezüglich seiner Längsachse symmetrisch ausgebildet, weist also die Symmetrieachse 13 auf. Das Horn 2 enthält eine Bohrung 17 zur Aufnahme einer Kapillare 18. Die Bohrung 17 ist mit einem in Längsrichtung des Horns 2 verlaufenden Schlitz 19 verbunden. Eine weitere, den Schlitz 19 durchstossende Bohrung 20 ist quer zur Symmetrieachse 13 des Horns 2 angebracht. Die Bohrung 20 endet beidseitig in Vertiefungen 21 des Horns 2. Die beiden Vertiefungen 21 sind ebenfalls symmetrisch zueinander ausgebildet. Die Vertiefungen 21 nehmen den Kopf einer in die Bohrung 20 eingesetzten Schraube 22 bzw. eine mit der Schraube 22 zusammenwirkende Mutter 23 wenigstens teilweise auf. Der Kopf der Schraube 22, die Länge der Schraube 22 und die Grösse der Mutter 23 sind so aufeinander abgestimmt, dass die Masse des Kopfes der Schraube 22 und die Masse der Mutter 23 zusammen mit der Masse des sich ausserhalb der Mutter 23 befindlichen Schraubenendes annähernd gleich gross sind. Diese bezüglich der Symmetrieachse 13 des Horns 2 symmetrische Masseverteilung von Schraube 22 und Mutter 23 bewirkt eine bezüglich der Längsachse symmetrische Ausbildung der Ultraschallwellen und damit eine optimale Bewegung der Kapillare 18. Die die Mutter 23 aufnehmende Vertiefung 21 ist mit Vorteil in Form und Durchmesser so auf die Mutter 23 abgestimmt, dass die in die Vertiefung 21 eingelegte Mutter 23 sich nicht mehr drehen kann.

Die Fig. 7 zeigt ein Befestigungsmittel, das anstelle der Schraube 22 und der Mutter 23 verwendet werden kann. Die Schraube 22 mit ihrem Kopf ist ersetzt durch ein Gewinde 24 und eine zweite Mutter 25. Dieses Befestigungsmittel erlaubt eine Masseverteilung des Gewindes 24 und der beiden Muttern 23, 25, die vollständig symmetrisch zur Längsachse des Horns 2 ist, indem beim Fixieren der Kapillare die eine oder die andere der Muttern 23, 25 angezogen werden kann. Die Symmetrie der Masseverteilung kann messtechnisch überprüft werden, indem die elektrische Impedanz Z des Ultraschallwandlers 3 in Funktion der Frequenz f der vom Ultraschallwandler 3 erzeugten Ultraschallwellen gemessen wird. Die Fig. 8 zeigt ausschnittweise den Betrag B der Impedanz Z eines solches Spektrums. Dieses weist bei unsymmetrischer Masseverteilung von Schraube 22 und Mutter 23 bzw. von Gewinde 24 und den Muttern 23, 25 in der Nähe der gewünschten Resonanzfrequenz f_{R} der longitudinalen Schwingungen eine Nebenresonanz 26 auf, die zu einer Biegeschwingung des Horns 2 gehört. Die Nebenresonanz 26 kann die longitudinalen Schwingungen der Spitze 15 des Horns 2 stören, indem sie den longitudinalen Schwingungen transversale Schwingungen überlagert. Bei symmetrischer Masseverteilung verschwindet die Nebenresonanz 26.

## Patentansprüche

1. Ultraschallgeber (1) mit einem Horn (2) und mit einem Ultraschallwandler (3), der das Horn (2) mit Ultraschallwellen so beaufschlagt, dass sich in Längsrichtung des Horns (2) stehende Ultraschallwellen ausbilden, wobei am Ort eines Knotens (5) der Ultraschallwellen ein Flansch (4; 4'; 4") am Horn (2) oder am Ultraschallwandler (3) angeordnet ist, damit der Ultraschallgeber (1) an einem Ultraschallschweissgerät (9) befestigbar ist, **dadurch gekennzeichnet, dass** der Flansch (4; 4'; 4") eine derart grosse Länge (L₂; L₂'; L₂") aufweist, dass sich im Flansch (4; 4'; 4"), wenn er frei schwingen kann, stehende Ultraschallwellen ausbilden, die ebenfalls mindestens einen Knoten (10) aufweisen.

2. Ultraschallgeber nach Anspruch 1, **dadurch gekennzeichnet, dass** in dem mindestens einen Knoten (10) eine Bohrung (7; 8) angebracht ist, damit der Flansch (4'; 4") mit Schrauben am Ultraschallschweissgerät (9) befestigbar ist.

3. Ultraschallgeber nach Anspruch 1 oder 2, **dadurch gekennzeichnet, dass** der Flansch (4; 4'; 4") im Bereich der Bohrungen (7; 8) dicker ausgebildet ist, damit nur Flächen (14), die die Bohrung (7; 8) unmittelbar umgeben, mit dem Ultraschallschweissgerät (9) in Kontakt sind.

4. Ultraschallgeber nach einem der Ansprüche 1 bis 3, wobei das Horn (2) eine Bohrung (17) zur Aufnahme einer Kapillare (18) aufweist und wobei die Kapillare (18) mittels einer durch eine weitere Bohrung (20) gesteckten, mit einer Mutter (23) zusammenwirkenden Schraube (22) fixiert ist, **dadurch gekennzeichnet, dass** die Verteilung der Masse der Schraube (22) und der Mutter (23) symmetrisch bezüglich der Längsachse des Horns (2) ist.

## Claims

1. Ultrasonic transducer (1) with a horn (2) and with an ultrasonic converter (3) which applies ultrasonic waves to the horn (2) so that standing ultrasonic waves develop in the lengthwise direction of the horn (2) whereby a flange (4; 4'; 4") is arranged on the horn (2) or on the ultrasonic converter (3) at the location of a node (5) of the ultrasonic waves so that the ultrasonic transducer (1) is attachable by means of screws to an ultrasonic welding device (9), **characterized in that** the flange (4; 4'; 4") has such a large length (L₂; L₂'; L₂") that in the flange (4; 4'; 4"), when it can freely oscillate, standing ultrasonic waves develop which also have at least one node (10).

2. Ultrasonic transducer according to claim 1, **characterized in that** a drill hole (7; 8) is present in the at least one node (10) in order that the flange (4'; 4") is attachable to the ultrasonic welding device (9) by means of screws.

3. Ultrasonic transducer according to claim 2, **characterized in that** the flange (4; 4'; 4") is formed thicker in the area of the drill hole (7; 8) so that only surfaces (14) which immediately surround the drill hole (7; 8) are in contact with the ultrasonic welding device (9).

4. Ultrasonic transducer according to one of claims 1 to 3 whereby the horn (2) has a drill hole (17) for acceptance of a capillary (18) and whereby the capillary (18) is secured by means of a screw (22) inserted through a further drill hole (20) in combination with a nut (23), **characterized in that** the distribution of the masses of the screw (22) and the nut (23) is symmetrical in relation to the longitudinal axis of the horn.

## Revendications

1. Générateur d'ultrasons (1) possédant un cornet (2) et un transducteur d'ultrasons (3) qui expose le cornet (2) à des ondes ultrasonores de telle sorte qu'il se crée dans l'axe longitudinal du cornet (2) des ondes ultrasonores stationnaires, une flasque (4; 4'; 4") étant disposée sur le cornet (2) ou le transducteur d'ultrasons (3) au niveau d'un noeud (5) des ondes ultrasonores pour permettre la fixation du générateur d'ultrasons (1) sur une machine de soudage par ultrasons (9), **caractérisé en ce que** la flasque (4; 4'; 4") présente une longueur (L₂; L₂'-L₂") telle qu'il se forme dans la flasque (4; 4'; 4"), lorsqu'elle peut osciller librement, des ondes ultrasonores stationnaires qui présentent elles aussi au moins un noeud (10).

2. Générateur d'ultrasons selon la revendication 1, **caractérisé en ce qu'**un alésage (7 ; 8) est disposé dans le noeud (10) au nombre d'un au moins afin de permettre la fixation de la flasque (4'; 4") à la machine de soudage par ultrasons (9) à l'aide de vis.

3. Générateur d'ultrasons selon la revendication 2, **caractérisé en ce que** la flasque (4; 4'; 4") est plus épaisse au niveau de 1' alésage (7 ; 8) afin que seules les surfaces (14) qui entourent immédiatement 1' alésage (7 ; 8) soient en contact avec la machine de soudage par ultrasons (9).

4. Générateur d'ultrasons selon l'une quelconque des revendications 1 à 3, dans lequel le cornet (2) présente un alésage (17) destiné à recevoir un capillaire (18) et dans lequel le capillaire (18) est fixé au moyen d'une vis (22) insérée dans un autre alésage (20) et coopérant avec un écrou (23), **caractérisé en ce que** la répartition des masses de la vis (22) et de l'écrou (23) est symétrique par rapport à l'axe longitudinal du cornet.
